# EUROPEAN PATENT APPLICATION

(11) **EP 4 651 678 A2**
(43) Date of publication of application: **19.11.2025**
(21) Application number: 25175946.0
(22) Date of filing: 13.05.2025
(51) Int. Cl.: H10F 30/225, H10F 39/10, H10F 77/14, H10F 77/30, H10F 77/70

(54) **PHOTONIC SURFACE-TOPOGRAPHY IN SINGLE PHOTON AVALANCHE DIODES**

(30) Priority: 14.05.2024 US 202418663433
(71) Applicant: Avago Technologies International Sales Pte. Limited, Singapore 768923 (SG)
(72) Inventor: Schmailzl, Wolfgang, Irvine, 92618 (US); Piemonte, Claudio, Irvine, 92618 (US)
(74) Representative: Dilg, Haeusler, Schindelmann Patentanwaltsgesellschaft mbH

(57) **Abstract**

A photodetector with a photonic surface topography is provided. The photodetector includes a semiconductor layer (110) having a top surface, a body having a first type of doping, and a first region (125) having a second type of doping different from the first type. A first fraction of a surface area of the top surface of the semiconductor layer (110) comprises a surface topography. The semiconductor layer (110) further includes a junction (120) formed between the body and the first region (125), wherein the junction (120) is configured to have respective surface area that is a second fraction of the surface area of the top surface, wherein the second fraction is smaller than the first fraction.

## Description

### COPYRIGHT STATEMENT

A portion of the disclosure of this patent document contains material that is subject to copyright protection. The copyright owner has no objection to the facsimile reproduction by anyone of the patent document or the patent disclosure as it appears in the Patent and Trademark Office patent file or records, but otherwise reserves all copyright rights whatsoever.

### FIELD

The present disclosure relates, in general, to methods, systems, and apparatuses for improving performance in silicon photomultipliers and other photodetector arrays.

### BACKGROUND

Efficient detection of light in a semiconductor sensor relies on the optimization of both the photon transmission to the device and its absorption in the semiconductor. Photon transmission is increased by the use of anti-reflective coatings (ARCs). Typically, ARCs are created by stacking dielectric layers with appropriate respective thicknesses and refractive indices. Stacking of dielectric layers presents many challenges, depending on fabrication process, the wavelengths to be transmitted, and mechanical and environmental stability of the device passivation layer.

Another approach is to create a broadband ARC through surface texturing. In this approach, photon absorption may be optimized by detector design selection. For example, the absorption length of near infrared light can be tens of micrometers which implies a thick layer or proper light trapping structures to increase the optical path in the active area. Thus, depending on the type of sensor, optimization of these two features presents challenges.

In a front-side illuminated single-photon avalanche diode (SPAD), both approaches to creating an ARC are difficult to implement in a cost-effective manner, especially for red/near infrared light detection. In conventional SPAD designs, a planar surface is utilized to create a uniform electric field for avalanche multiplication. A texturing of the surface may disrupt the field configuration or reduce optical performance of the SPAD.

Thus, a photonic surface topography for front side illuminated single-photon avalanche diodes is provided.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Fig. 1 is a partial schematic cross-sectional view of an SPAD array, in accordance with various embodiments;
Fig. 2 is a partial schematic top view of an SPAD array, in accordance with various embodiments;
Fig. 3 is a partial schematic cross-sectional view of an alternative configuration of an SPAD array, in accordance with various embodiments;
Fig. 4 is a partial schematic cross-sectional view of an SPAD array featuring a trench, in accordance with various embodiments;
Fig. 5 is a partial schematic cross-sectional view of an alternative configuration of an SPAD array featuring an insulation layer, in accordance with various embodiments;
Fig. 6 illustrates respective schematic cross-sectional views of several surface topographies, in accordance with various embodiments;
Fig. 7 illustrates a schematic perspective view of a photonic surface topography featuring holes, in accordance with various embodiments;
Fig. 8 illustrates a schematic perspective view of a photonic surface topography featuring multiple layers of holes and rods, in accordance with various embodiments;
Fig. 9 illustrates a schematic perspective view of a photonic surface topography featuring a lattice structure, in accordance with various embodiments.

### DETAILED DESCRIPTION OF EMBODIMENTS

Various embodiments set forth a photonic surface-topography for front side illuminated SPADs.

In some embodiments, a photodetector with a photonic surface-topography is provided. The photodetector includes a semiconductor layer having a top surface, a body having a first type of doping, and a first region having a second type of doping different from the first type. A first fraction of a surface area of the top surface of the semiconductor layer comprises a surface topography. The semiconductor layer further includes a junction formed between the body of the semiconductor and the first region, wherein the junction is configured to have respective surface area that is a second fraction of the surface area of the top surface, wherein the second fraction is smaller than the first fraction. An electrode is coupled to the first region.

In further embodiments, an apparatus for featuring a photonic surface-topography is provided. The apparatus includes a semiconductor layer having a first surface. The semiconductor layer includes a body having a first type of doping, and a first region having a second type of doping different from the first type. A first fraction of a surface area of the first surface of the semiconductor layer comprises a surface topography. The semiconductor layer further includes a junction formed between the body of the semiconductor and the first region. The junction is configured to have a surface area that is a second fraction of the surface area of the first surface, wherein the second fraction is smaller than the first fraction.

In further embodiments, photodetector array with a photonic surface-topography is provided. The photodetector array includes a plurality of photodetectors disposed on a substrate in a grid arrangement, the plurality of photodetectors including a first photodetector. The first photodetector includes a semiconductor layer having a top surface on a first side, wherein the semiconductor layer is configured to allow light to enter via the first side. The semiconductor layer includes a body having a first type of doping, and a first region having a second type of doping different from the first type. A first fraction of a surface area of the top surface of the semiconductor layer comprises a surface topography. The semiconductor layer further includes a junction formed between the body of the semiconductor and the first region. The junction is configured to have respective surface area that is a second fraction of the surface area of the top surface, wherein the second fraction is smaller than the first fraction.

In the following description, for the purposes of explanation, numerous details are set forth to provide a thorough understanding of the described embodiments. It will be apparent to one skilled in the art, however, that other embodiments may be practiced without some of these details. Several embodiments are described herein, and while various features are ascribed to different embodiments, it should be appreciated that the features described with respect to one embodiment may be incorporated with other embodiments as well. By the same token, however, no single feature or features of any described embodiment should be considered essential to every embodiment of the invention, as other embodiments of the invention may omit such features.

When an element is referred to herein as being "connected" or "coupled" to another element (which includes mechanically, electrically, or communicatively connecting or coupling), it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

Conventional ARCs have proven challenging to implement in SPAD designs. In typical SPADs, an electrical potential is applied to the n⁺ and p⁻ region to create a high electric field at the junction, which enables avalanche multiplication if the potential is above the breakdown voltage. SPADs are operated above the breakdown voltage with the design goal to create a uniformly distributed avalanche region. The n⁺ region is typically created using ion implantation in an epitaxial p- layer on a p+ substrate. When an anti-reflective (AR) texturing is applied to a planar wafer surface, it is followed by subsequent ion implantation to create the n⁺ region. This process can affect the shape of the n⁺ region, creating a non-uniform avalanche region. Alternatively, the region can be doped first, but this modification to the process has resulted in a decrease in the volume of the optically active region.

Accordingly, an SPAD with a photonic surface-topography is provided. Specifically, an SPAD is provided in which a point-like n⁺ region (and/or a point-like p-n junction between the n⁺ region and surrounding semiconductor body) is combined with a surface nano-topography on a planar wafer surface facing a front-side (e.g., illuminated side). By leveraging the point-like high-field region, an AR surface nano-topography can be applied to the epitaxial layer surface while mitigating its effects on the avalanche region.

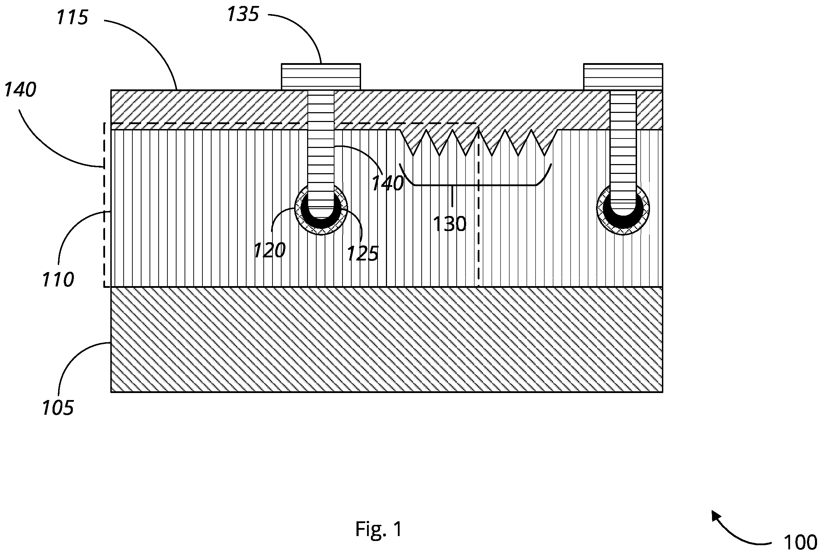

Fig. 1 is a partial schematic cross-sectional view of an SPAD array 100, in accordance with various embodiments. The SPAD array 100 includes a substrate 105, a semiconductor layer 110, dielectric layer 115, electrode 135, avalanche region 120, n-doped region 125, and surface texturing 130. The various elements of the SPAD array 100 are schematically illustrated in Fig. 1, and that modifications to the various components and other arrangements of the SPAD array 100 may be possible and in accordance with the various embodiments.

In various embodiments, the SPAD array 100 may be a photodetector array include a plurality of individual photodetector cells, in this case individual SPADs. The SPAD array 100 may be referred to interchangeably as a silicon photomultiplier (SiPM). For purposes of explanation, the embodiments below are described with reference to the structures of an individual SPAD. However, as described previously, an SPAD array 100 comprises a plurality of individual SPADs. In some examples, the SPAD array 100 may comprise two or more individual SPADs. In other embodiments, the SPAD array 100 may comprise tens, hundreds, thousands, millions or more individual SPADs. For example, in some embodiments, the SPAD array 100 may include at least 100,000 respective SPADs.

In various embodiments, the substrate 105 may be a silicon substrate on which the other structures of the SPAD array 110 are formed. Accordingly, the substrate 105 may be a semiconductor substrate, such as, without limitation, bulk silicon. In some embodiments, the substrate 105 may be highly p-doped (p⁺), formed by heavy doping with p-type dopants (e.g., boron). The substrate 105, accordingly, serves as the "bulk" semiconductor of the SPAD array 100 on (or within) which other parts of the device are formed, such as the semiconductor layer 110, dielectric layer 115, n-doped region 125, and electrode 135.

The semiconductor layer 110 may be disposed on the substrate 105. In some examples, the semiconductor layer 110 may be an epitaxial layer (e.g., a layer of semiconductor material grown on the substrate 105 via an epitaxial process). In various embodiments, the semiconductor layer 110 may be doped in-situ during the epitaxial growth process. For example, in some embodiments, the semiconductor layer 110 may be lightly p-doped (e.g., p⁻ doped). In some examples this may be referred to as a first type of doping, to differentiate from different subsequent types of dopings (e.g., second, third, etc.). It is to be understood that in other embodiments, the doping of the body of the semiconductor layer 110 may be referred to as differently numbered "type" of doping, such as the second, third, or other numbered "type" of doping, and that the order of the numbering of the type of dopings is merely used for differentiation between different types of doping. Thus, the body of the semiconductor layer 110 may thus be considered to be lightly p-doped. As used herein, the "body" may refer to the bulk / core of the semiconductor layer 110 (or semiconductor layer), in contrast with the surfaces of the semiconductor layer 110 (such as the top surface, or a bottom surface). Accordingly, the body may refer to the bulk, internal regions of the semiconductor layer 110.

Accordingly, in various embodiments, the semiconductor layer 110 may be formed of a semiconductor material, such as silicon. In other embodiments, other materials may be used, including, without limitation, germanium, III-V compound semiconductor material (e.g., gallium arsenide (GaAs), indium phosphide (InP), etc.), or II-VI compound semiconductor material (e.g., zinc oxide (ZnO), magnesium oxide (MgO), etc.).

In various examples, the semiconductor layer 110 may co-extend with the substrate 105. An optically active region 140 of the semiconductor layer 110 may be associated with a respective SPAD of the SPAD array 100, having a respective electrode 135 coupled to a respective n-doped region 125 and having a respective avalanche region 120.

In various examples, an n-doped region 125 may be formed within the semiconductor layer. For example, in some embodiments, the n-doped region may be a region formed via in-situ doping with using an n-type dopant (e.g., phosphorous). The n-doped region 125 may be heavily n-doped (e.g., n⁺ doped). In some examples, this may be referred to as a "second" type of doping, different from the first type previously described. Similarly, in some examples, the doping of the substrate (e.g., p⁺ doping) may also be referred to as a "first" type of doping, being p-type, but of a different concentration of doping (e.g., lower dopant concentration) than that of the body.

The n-doped region 125 may, in various embodiments, may be formed in a point-like size and shape. Thus, the n-doped region 125 may be focused within a relatively small area of the semiconductor layer 110. In various embodiments, the n-doped region 125 may be positioned at any depth within the semiconductor layer 110 (e.g., close to the surface or deep within the semiconductor layer 110). In some examples, the n-doped region 125 (and pillar 140) may be formed by first creating a cavity within the semiconductor layer 110 via dry etching, wet etching, or a combination of both dry etching and wet etching processes. Doping may then be applied in-situ (e.g., ion implantation or diffusion) to create the n-doped region 125.

In the embodiments above, and further embodiments set forth below, boron and phosphorous are provided as non-limiting examples, and it is to be understood that in other embodiments, other dopants may be utilized. For example, suitable dopants may include, without limitation, pentavalent atoms (e.g., arsenic, phosphorous, antimony, bismuth, lithium, etc.) for n-type doping and trivalent atoms (e.g., indium, aluminum, gallium, boron, etc.) for p-type doping. Moreover, as used herein, lightly doped and heavily doped may be relative in relation to each other (e.g., a lightly doped region is doped with a relatively lower concentration of dopants compared to a heavily doped region). In some examples, a lightly doped region may be doped with dopant atoms in the range of parts per million (ppm) or less. In contrast, a heavily doped region may be doped with dopant atoms in the range of parts per thousand or more.

In the embodiments above, and further embodiments set forth below, boron and phosphorous are provided as non-limiting examples, and it is to be understood that in other embodiments, other dopants may be utilized. For example, suitable dopants may include, without limitation, pentavalent atoms (e.g., arsenic, phosphorous, antimony, bismuth, lithium, etc.) for n-type doping and trivalent atoms (e.g., indium, aluminum, gallium, boron, etc.) for p-type doping.

In various examples, the n-doped region 125 may be referred to as a "head," which is coupled to a first end of the pillar 140. The pillar 140 may in turn be coupled to the electrode 135 and/or part of the electrode 135. The n-doped region 125 may be formed to have a respective three-dimensional geometry. For example, in some embodiments, the n-doped region 125 may have a spherical geometry. In other examples, the n-doped region 125 may have a different geometry, such as, without limitation, ellipsoidal, pyramidal, tetrahedral, other polyhedral, conical, or other shape. In yet further examples, the n-doped region 125 may be semi-spherical or semi-ellipsoidal in shape. In the example depicted, the n-doped region 125 is spherical.

Similarly, the pillar 140 may have different cross-sectional shapes. Accordingly, the pillar 140 may be, without limitation, cylindrical (e.g., a circular or elliptical cross-section) or a rectangular pillar (e.g., a rectangular or square cross-section). In other examples, the pillar 140 may be conical, polyhedral, or otherwise have a different shape, and is not limited to any specific form-factor. In some examples, the n-doped region 125 and/or pillar 140 may, at least partially, be surrounded by a dielectric material (e.g., an insulation layer), configured to electrically isolate at least part of the pillar 140 and/or part of the n-doped region 125 from directly contacting the semiconductor layer 110. In other embodiments, the dielectric material may surround the pillar 140 such that only the n-doped region 125 is in direct contact with the semiconductor layer 110. In various examples, the dielectric material may, for example, be formed of silicon oxide.

In various embodiments, the pillar 140 may be configured to electrically couple the n-doped region 125 to the electrode 135. Accordingly, in some examples, the pillar 140 may be formed of a conductive material, such as copper or other suitable metal, or polysilicon.

Accordingly, by employing an n-doped region 125 as described above, coupled to the electrode 135 via the pillar 140, a point-like high field region (e.g., avalanche region 120) may be formed at p-n junction between the n-doped region 125 and lightly p-doped semiconductor layer 110. The avalanche region 120, accordingly, may refer to the region around the p-n junction between the n-doped region 125 and the surrounding semiconductor layer 110, configured to undergo avalanche breakdown. In some examples, the n-doped region 125 may, thus, be a point-like region embedded into the semiconductor layer 110, resulting in a corresponding point-like junction (and high field region) being formed between the semiconductor layer 110 and n-doped region 125.

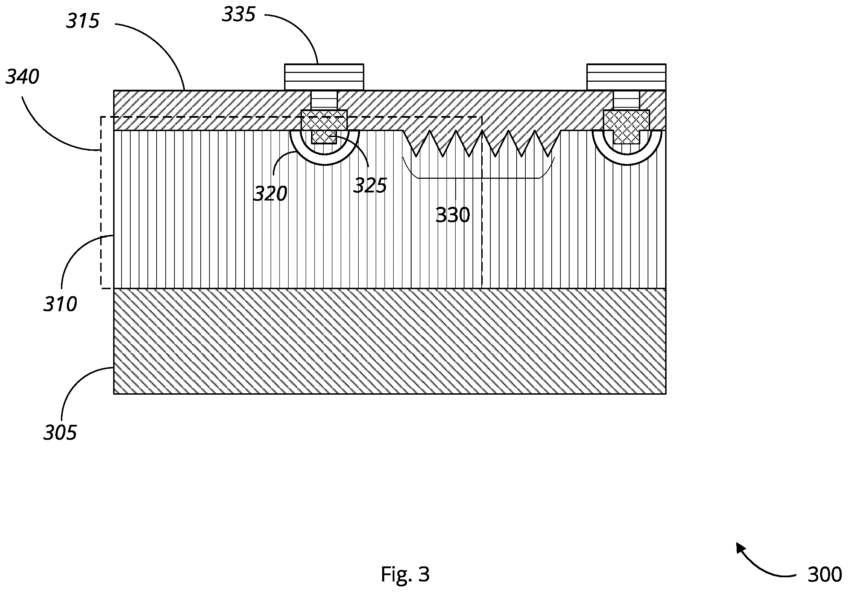

In some examples, n-doped region 125 may be disposed directly at the junction between the dielectric layer 115, and semiconductor layer 110, as depicted in Figs. 3-4. In various embodiments, the n-doped region 125 may be formed of a semiconductor material that is different from that used in the semiconductor layer 110. For example, in some embodiments, the n-doped region 125 may be formed of polysilicon.

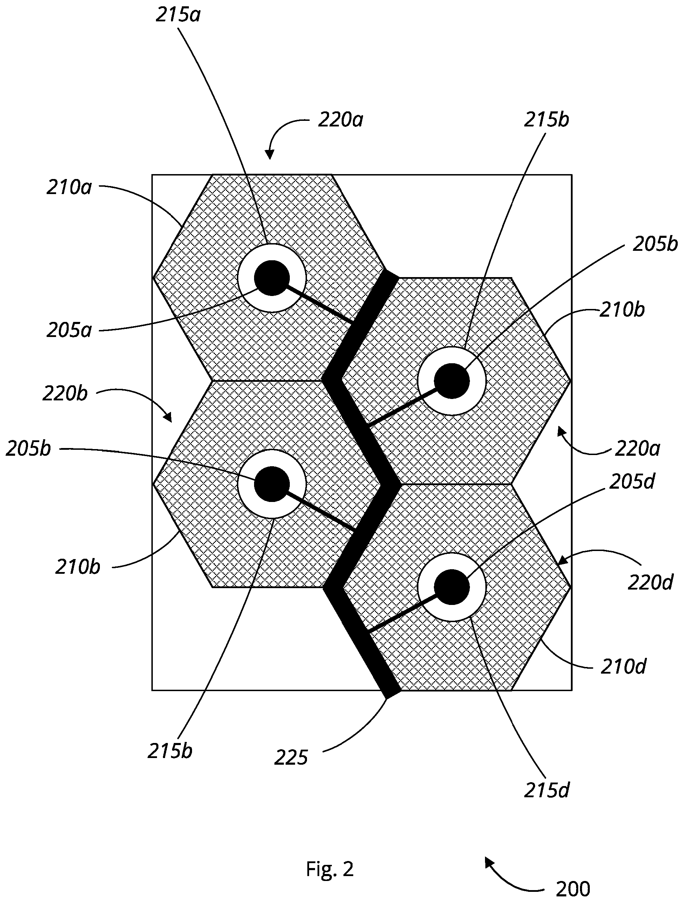

"Point-like," as used herein, may refer to the n-doped region 125 itself, or the p-n junction formed between the n-doped region 125 and semiconductor layer 110 (or other semiconductor layer), and/or the high field region formed around the p-n junction. In various embodiments, "point-like" is used to contrast with conventional approaches, in which the n-doped region is planar in shape, extending across the entire surface, or at least across large portions of the surface. Thus, a junction may correspondingly be "planar" in shape, covering a large portion of a surface of the epitaxial and/or semiconductor layer. In contrast, the n-doped region 125, and n-doped regions described below with respect to Figs. 2-5, may provide for an n-doped region that is localized (e.g., not planar), and configured to create a junction with a surrounding epitaxial layer / semiconductor layer having an area that is a relatively smaller fraction of the surface area than in planar arrangements of the n-doped region. In some examples, this may be a tiny fraction of the overall surface area of the epitaxial layer / semiconductor layer.

In some examples, a surface texturing 130 may be provided on a top surface (alternatively, a "first surface") on a first side of the semiconductor layer 110. Accordingly, in various embodiments, the surface topography may be created by a surface texturing 130. The surface topography (e.g., surface texturing 130) may cover a first fraction of the surface area of a top surface of the semiconductor layer 110. In other words, a first fraction of the surface area of the top surface of the semiconductor layer 110 may feature a surface topography (e.g., via surface texturing 130). In some examples, areas of the top surface in contact with the n-doped region, or alternatively, disposed above the junction (e.g., p-n junction) created between the point-like n-doped region 125 and semiconductor layer 110, may be excluded from having the surface topography (e.g., surface texturing 110). Thus, a second fraction of the surface area of the top surface of the semiconductor layer 110 may not include surface topography. In some examples, the surface area of the junction may be equal to the second fraction of the surface area of the top surface of the semiconductor layer 110.

For example, in some embodiments, the ratio of the surface area of the junction (e.g., the surface area of the top surface positioned above the junction, also referred to as the "buffer" area) to the surface area of the surface topography (surface texturing 130) may be a ratio of 1 to at least 10 (e.g., greater than 10). In other words, the first fraction of the surface area of the top surface featuring surface texturing 130 may be at least 10/11. In some examples, the first fraction of the surface area of the top surface featuring surface texturing 130 may be at least 7/10 (e.g., at least 70% of the top surface includes the surface texturing 130). In yet further examples, at least 50% of the top surface includes surface texturing 130.

An electrical potential may be applied to the n⁺ (e.g., n-doped region 125) and p⁻ region (e.g., semiconductor layer 110), which creates a high electric field at the junction between the n-doped region 125 (e.g., n⁺ doped region) and lightly p-doped region of the semiconductor layer 110, which may allow for avalanche multiplication within avalanche region 120. Thus, a uniformly distributed, point-like (e.g., focal), in this example, spherically shaped avalanche region 120 may be formed in an area surrounding the n-doped region 125 (e.g., around the "head" of the pillar 140).

Accordingly, in various embodiments, a high field region (e.g., an avalanche region 120) may be formed around the head (e.g., the n-doped region 125), effectively forming a "shell" surrounding the n-doped region 125. A larger sensitive area may further be created around the avalanche region 120 in which photons absorbed in the sensitive area generate electron-hole pairs. When the electrons reach the avalanche region 120, an avalanche breakdown occurs, resulting in the multiplication of carriers flowing through the n-doped region (e.g., collected in the head). As used herein, the avalanche region 120 may be referred to interchangeably as the high field region.

Accordingly, as described above the electrode 135 may include a conductive pad, trace, or other conductive structure via which electrical biasing may be applied to the n-doped region 125 and/or voltages measured. Accordingly, a pad, as used herein, may refer to a signal pad, input/output pad, attenuating pad, or other conductive structure within the circuit from which a signal may be applied and/or measured. The electrode 135 may, in various examples, be formed of a conductive material, such as metal (e.g., tungsten (W), copper (Cu), or other suitable material), polysilicon, or a conductive oxide.

In various embodiments, the semiconductor layer 110 may feature surface texturing 130 on a side facing a light source (e.g., a front side facing a light source). The surface texturing 130, accordingly, may be disposed on a front side (e.g., a side facing a light source or a side through which light may enter the semiconductor / epitaxial layer) of the semiconductor layer 110, alternatively referred to as a "top" side, or a "first" side. Although shown cross-sectionally (and thus only across one axis), it is to be understood that the topological features of the surface texturing 130 can extend in all directions along the top surface of the semiconductor layer 110. Accordingly, the surface texturing 130, according to various embodiments, may cover at least part of the first side of the entire SPAD array 100, and thus at least part the top sides of each of the plurality of individual SPADs of the SPAD array 100. In some examples, the surface texturing 130 covers (e.g., is present in) at least half of the surface area of the first side of the semiconductor layer 110. In yet further embodiments, the surface texturing 130 may cover the entire first side of the semiconductor layer 110 excluding a buffer area surrounding the pillar 140, electrode 135, and/or n-doped region 125.

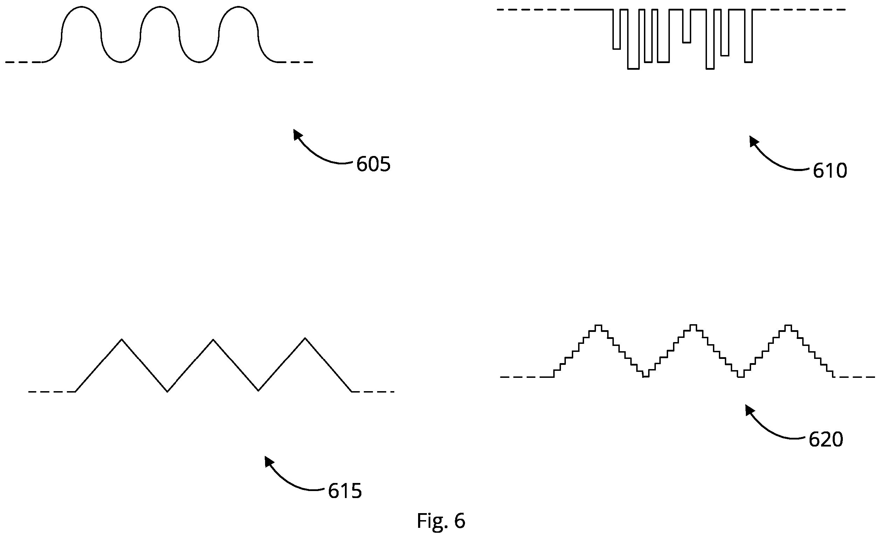

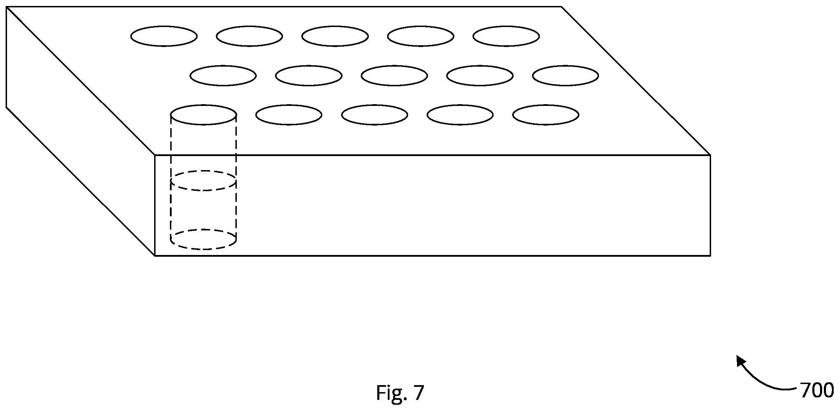

In various examples, the surface texturing 130 may have a photonic surface topography configured to provide broadband, omnidirectional AR properties. In some embodiments, the surface texturing 130 may be a surface topography with photonic characteristics (e.g., a photonic surface topography), that exhibits further photonic features, such as improving absorption of light within the semiconductor layer 110. Accordingly, a photonic surface topography, as used herein, refers to a surface topography (e.g., of the surface texturing 130) that is configured to interact with photons to produce an effect, as described above (e.g., AR, improved absorption, etc.). Accordingly, in some examples, the surface texturing 130 may be configured to have a surface topography that is configured to reduce reflections across a wide range of wavelengths (e.g., an AR surface topography). In some examples, the surface texturing 130 may be configured to confine light / photons once it has entered the semiconductor layer 110. In some examples, the surface topography may be biomimetic nanostructures (e.g., nanostructures mimicking structures found in nature, such as a moth's eye. Accordingly, in some examples, the surface topography of the surface texturing 130 may be a paraboloid nipple array, as depicted in Fig. 7. In other examples, other surface topographies may be used, such as porous silicon, in which nanometer-sized voids (e.g., less than a wavelength in size) with a large hydrogenated surface may be created on the first side of the semiconductor layer 110. In yet further examples, the surface topography may be pyramidal, or have another polyhedral shape, or may be implemented as a grating. While the various photonic surface topographies have been described as surface texturing 130, it is to be understood that in other embodiments, surface topographies may be created as photonic structures on a surface of the semiconductor layer (such as semiconductor layer 110). Examples of the surface topographies are described in greater detail below with respect to Figs. 6-9. Accordingly, the surface topography may generally refer to features of a surface or features formed on the surface, such as the semiconductor layer.

In various embodiments, the dielectric layer 115 may be disposed on the semiconductor layer 110 (including the surface texturing 130), and provide further electrical insulation to the pillar 140 and/or n-doped region 125. Specifically, the dielectric layer 115 may be disposed on a first side (e.g., illumination / light source facing side) of the semiconductor layer 110. In some examples, the dielectric layer 115 may be disposed on (e.g., deposited or otherwise formed over) the semiconductor layer 110 after surface texturing 130 has been created. Thus, the dielectric layer 115 may be disposed on the first side (e.g., a top surface) of the semiconductor layer 110. The dielectric layer 115 may, in some examples, be formed of silicon oxide (SiO).

Fig. 2 is a partial schematic top view of an SPAD array 200, in accordance with various embodiments. The SPAD array 200 comprises a plurality of SPADs (referred to interchangeable as "cells"), including SPADs 220a-220d, including a first SPAD 220a through fourth SPAD 220d. The first SPAD 220a includes a first high field region 205a, respective AR surface texturing 210a, and respective buffer region 215a. The second SPAD 220b includes a second high field region 205b, respective AR surface texturing 210b, and respective buffer region 215b. The third SPAD 220c includes a third high field region 205c, respective AR surface texturing 210c, and respective buffer region 215c. Similarly, the fourth SPAD 220d includes a fourth high field region 205d, respective AR surface texturing 210d, and respective buffer region 215d. The SPAD array 200 further includes a conductive trace 225 coupled to each of the respective electrodes, and the high field regions 215a-215b of the SPADs 220a-220d. It should be noted that the various elements of the SPAD array 200 are schematically illustrated in Fig. 2, and that modifications to the various components and other arrangements of the SPAD array 200 may be possible and in accordance with the various embodiments.

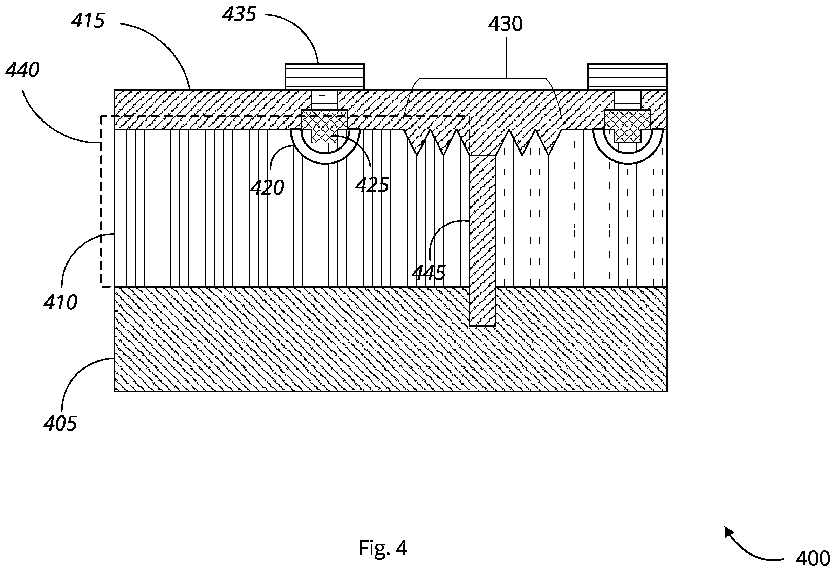

In some embodiments, each SPAD 220a-220d may be surrounded by a trench (as shown in Figs. 4-5). In some examples, the trench may be filled, for example, with a dielectric material, metal, or other material. In some embodiments, the cells (e.g., SPADs 220a-220b) may be arranged in a grid arrangement, such as a hexagonal grid. In other embodiments, other arrangements of cells may be utilized, such as a rectangular grid.

In various examples, each of the SPADs 220a-220d may be coupled to a common feed line (e.g., the conductive trace 225). In some examples, each SPAD 220a-220d may be coupled to the conductive trace 225, via a quenching resistor. In some examples, each SPAD 220a-220d may be coupled to the conductive trace 225 via respective conductive lines (e.g., a wire, conductive trace, or other connection). In yet further examples, each SPAD 220a-220d may individually be fed by a respective feed line (e.g., not coupled to a common feed line, such as the conductive trace 225).

As depicted, each of the high field regions 215a-215d (e.g., avalanche region) of the SPAD array 200 are distributed evenly, centered within each respective cell. The high field region 215a-215d, as viewed from the top, may include the electrode, beneath which, in some examples, the pillar may extend through the dielectric layer and into the semiconductor layer of the respective SPAD 220a-220d, and a respective n-doped region (e.g., head). The n-doped region may further be disposed inside the semiconductor layer and beneath the electrode.

In further embodiments, the high field regions 215a-215d (and therefore the cells of the SPAD array 200) may be distributed with variable density, according to a specific mapping. For example, in some embodiments, different regions of the SPAD array may have a higher (or lower) density of high field regions per area (and correspondingly higher cell count per area). Areas with higher density may exhibit relatively higher sensitivity, while less density areas exhibit relatively lower sensitivity. For example, in some embodiments, one (or several) of the SPADs 220a-220d may have more pillars and/or junctions than the other SPADs 220a-220d of the SPAD array 200.

AR surface texturing 210a-210d disposed on the top surface (e.g., a first side) of the semiconductor layer of each respective cell. In some examples, the AR surface texturing 210a-210d is present throughout the top surface of the respective semiconductor layers with the exception of a buffer region surrounding each respective high field region 215a-215d (or alternatively, surrounding each cell's respective electrode, n-doped region, or larger sensitive region surrounding the high field region). As the high field region is highly localized (e.g., point-like) surrounding the head (e.g., the n-doped region coupled to a conductive pillar, or a first end of a n-doped region as depicted in Figs. 3-5), the buffer region may be optional and/or small in size (e.g., close in size relative to the high field region or sensitive region, and smaller in comparison to areas featuring the AR surface texturing 210a-210d).

Fig. 3 is a partial schematic cross-sectional view of an alternative configuration of an SPAD array 300, in accordance with various embodiments. The SPAD array 300 includes a substrate 305, a semiconductor layer 310, dielectric layer 315, electrode 335, avalanche region 320, n-doped region 325, and surface texturing 330. The various elements of the SPAD array 300 are schematically illustrated in Fig. 3, and that modifications to the various components and other arrangements of the SPAD array 300 may be possible and in accordance with the various embodiments.

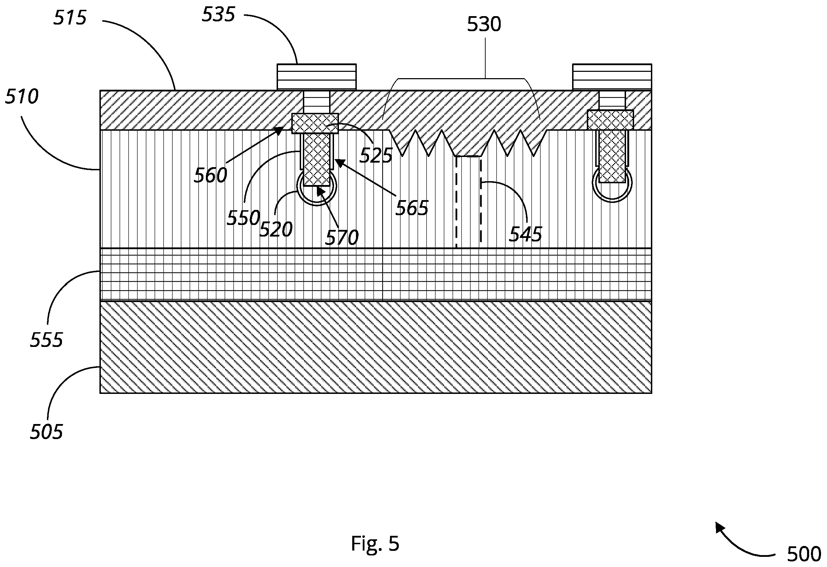

In contrast with the cells (e.g., individual SPAD) of the SPAD array 100, the n-doped region 325 is located at the interface between the top surface (e.g., a first side) of the semiconductor layer 310 and the dielectric layer 315. Moreover, no dielectric channel is present between the n-doped region 325 and the surrounding optically active area 340 (e.g., the p⁻ doped area) of the semiconductor layer 310. Thus, the p-n junction between the n-doped region 325 and semiconductor layer 310, and correspondingly the avalanche region 320, is moved closer to the top surface (e.g., first side) of the semiconductor layer 310. Thus, the n-doped region 325 is disposed at the interface between the dielectric layer 315 and semiconductor layer 310, as opposed to being disposed inside the semiconductor layer 110 at the end of a pillar 140 or channel (as shown in Fig. 5) as in the SPAD array 100 of Fig. 1.

However, it is to be understood that in other embodiments, the n-doped region 325 may include a column that extends into the semiconductor layer 310. For example, in some further embodiments, the n-doped region 325 may include a column and a "tip" as previously described. The tip of the n-doped region 325 may be located within the semiconductor layer 310. The n-doped region 325 may thus have a "T-shaped" structure, in which the top of the "T" is disposed on (e.g., on the top surface of) the semiconductor layer 310, while the column of the n-doped region 325 extends from the top of the "T," downward into the semiconductor layer 310 (as depicted in Fig. 5), wherein a channel is formed longitudinally extending downward into the semiconductor layer 310. In some examples, the column of the n-doped region 325 may be surrounded by a dielectric material, such as the dielectric material of dielectric layer 315, (e.g., electrically insulated), such that only the tip of the n-doped region (e.g., a first end of the column on the opposite the top surface) is the only part in direct contact with the semiconductor layer 310. In this arrangement, the p-n junction is pushed lower into the semiconductor layer 310 (and corresponding avalanche region 320), as in the arrangement of the cells of the SPAD array 100 of Fig. 1.

Accordingly, in various embodiments, the n-doped region 325 may itself be an electrode (e.g., a second electrode) disposed at the top surface of the semiconductor layer 310, coupled to electrode 335 (e.g., a first electrode) which may be configured to bias the n-doped region 325 as previously described with respect to Fig. 1. In some examples, the n-doped region 325 may extend, at least partially, into the semiconductor layer 310. The portion of the n-doped region 325 extending into the semiconductor layer 310, and therefore making direct contact with the semiconductor layer 310 forming the p-n junction, may be referred to as the "tip" of the n-doped region 325. The tip-end of the n-doped region 325 may, in some examples, be referred to as a "first end."

Thus, in this arrangement, where the n-doped region 325 does not extend into the semiconductor layer 310, the avalanche region 320 is correspondingly shifted closer to the top surface. Thus, in some embodiments, the n-doped region 325 is a polysilicon structure that is disposed on the semiconductor layer 310, with a tip that extends at least partially into the semiconductor layer 310 from the top surface, as opposed to an n-doped region 125 formed within the semiconductor layer 110 as in SPAD array 100. Thus, a p-n junction is created at and/or near the top surface (e.g., first side) of the semiconductor layer 310.

Fig. 4 is a partial schematic cross-sectional view of an SPAD array 400 featuring a trench, in accordance with various embodiments. Like SPAD array 300, SPAD array 400 includes substrate 405, semiconductor layer 410, dielectric layer 415, electrode 435, avalanche region 420, n-doped region 425, and surface texturing 430. However, SPAD array 400 further features trenches, such as trench 445. The various elements of the SPAD array 400 are schematically illustrated in Fig. 4, and that modifications to the various components and other arrangements of the SPAD array 400 may be possible and in accordance with the various embodiments.

As previously described with respect to the SPAD array 300 of Fig. 3, the n-doped region 425 is disposed on the top surface of the semiconductor layer 410. However, in contrast with the SPAD array 300, the SPAD array 400 includes one or more respective trenches, including trench 445. In various embodiments, the respective cells (e.g., individual SPADs) may be separated by the trench 445. Introducing deep trenches (e.g., trenches that extend from the dielectric layer 415 and at least partially into the substrate 405), as a cell separator reduces the optical crosstalk between neighboring cells. This may commonly be referred to as deep trench isolation (DTI). Accordingly, a trench 445 may be a channel formed in the semiconductor layer 410, configured to optically isolate the respective SPAD cell from other SPAD cells.

The addition of a surface topography, such as in surface texturing 430, does not prevent the implementation of trenches (including trench 445) of various materials or different layouts. In some examples, the trenches may be filled with the same dielectric material as in dielectric layer 415 (e.g., SiO, etc.). In other examples, the trenches may be filled with other material, such as metal (e.g., W, Cu, etc.).

Fig. 5 is a partial schematic cross-sectional view of an alternative configuration of an SPAD array 500 featuring an intermediate dielectric layer, in accordance with various embodiments. The SPAD array 500 includes substrate 505, semiconductor layer 510, dielectric layer 515, electrode 535, avalanche region 520, n-doped region 525, surface texturing 530, and trench 545. In contrast with the cells of the SPAD arrays 100, 300, 400, the SPAD array 500 further features an insulation channel 550, and insulation layer 555. The various elements of the SPAD array 500 are schematically illustrated in Fig. 5, and that modifications to the various components and other arrangements of the SPAD array 500 may be possible and in accordance with the various embodiments.

As previously described with respect to Fig. 3, the n-doped region 525 of a cell of the SPAD array 500 may include a column that extends into the semiconductor layer 510. The n-doped region 525 may include a top 560, column 565, and a tip 570 as previously described. The tip of the n-doped region 525 may be located within the semiconductor layer 510. The n-doped region 325 may thus have a "T-shaped" structure, in which the top 560 of the "T" is disposed on (e.g., on the top surface of) the semiconductor layer 310, while the column 565 of the n-doped region 525 extends from the top 560 of the "T," downward into the semiconductor layer 510. Thus, in various embodiments, a channel may be formed within the semiconductor layer 510, which extends longitudinally downward, into the semiconductor layer 510.

In some examples, the column 565 of the n-doped region 525 may be surrounded by insulation channel 550. The insulation channel 550 may be a dielectric material, such as the dielectric material of dielectric layer 515 (e.g., SiO), which provides electrical insulation between the column 565 of the n-doped region 525 and the surrounding semiconductor layer 510. In this configuration, only the tip 570 of the n-doped region 525 (e.g., a first end of the column 565 on the opposite the top surface) is the only part in direct contact with the semiconductor layer 510. In this arrangement, the p-n junction is pushed lower into the semiconductor layer 510 (and corresponding avalanche region 520), as in the arrangement of the cells of the SPAD array 100 of Fig. 1.

In various embodiments, the SPAD array 500 further includes an insulation layer 555. The insulation layer 555 may be disposed on the substrate 505, between the substrate 505 and the semiconductor layer 510. The insulation layer 555 may be formed of a dielectric material, such as the dielectric material utilized in the dielectric layer 515 (e.g., SiO, etc.). In various embodiments, the insulation layer 555 may be configured to reflect light back into the optically active region of the cell, extending the photon path into the active region of the semiconductor layer 510, such as the high field region (e.g., avalanche region 520) or larger sensitive region surrounding the high field region. For example, in some embodiments, the insulation layer 555 may further include a metal layer within the dielectric material of the insulation layer 555. In some examples, the metal layer of the insulation layer 555 may extend in a coplanar direction with the dielectric material. In some embodiments, the metal layer may be a structure formed within the dielectric material, such as a wall that is coplanar, orthogonal, or angled, located inside the dielectric material.

In various embodiments, semiconductor layer 510, as used in the context of the SPAD array 500, may not be formed via an epitaxial process, in contrast with the semiconductor layers 110, 310, 410 previously described. The semiconductor layer 510 may instead be a semiconductor layer that is lightly p-doped (e.g., p⁻ doped) and disposed on the insulation layer formed via a silicon on insulator (SOI) process. Specifically, in some examples, the semiconductor layer 510 may be a semiconductor material (e.g., a silicon wafer) that is bonded to the insulation layer 555 via a wafer bonding process. In other examples, a separation by ion implantation (e.g., SIMOX) process may be used to create the insulation layer 555 and "epitaxial" layer 510.

In some examples, the SPAD array 500 may further optionally include trench 545, configured to separate adjacent (e.g., neighboring) SPAD cells. Specifically, in some examples, the trench 545 may extend between the dielectric layer 515 and the insulation layer 555. As previously described, the trench 545 may be implemented as part of DTI, optically and/or electrically insulating neighboring cells. In other examples, the SPAD array 500 may not feature trenches, such as trench 545.

In each of the SPAD arrays 100-500 of Figs. 1-5, the surface texturing 130, 210, 330, 430, 530 may be provided on the top surface (e.g., first side) of the semiconductor layer 110, 310, 410 and/or semiconductor layer 510, without interfering with the high field region (e.g., avalanche regions 120, 320, 420, 520) or other parts of the respective n-doped regions 125, 325, 425, 525, or other structures such as trenches 445, 545. Various AR topographies may be utilized in the surface texturing, as will be described below with respect to Fig. 6.

Fig. 6 illustrates respective perspective views of several surface topographies, in accordance with various embodiments. Specifically, surface texturing (such as surface texturing 130, 210, 330, 430, 530) may be provided at a semiconductor/dielectric interface (e.g., interface between a respective dielectric layer and semiconductor layer (including epitaxial layer)) as previously described. Surface texturing may be provided on "free" surfaces (e.g., a top surface) of the semiconductor and/or epitaxial layer, where the texturing does not interfere with high field regions (e.g., avalanche regions) or sensitive regions within or near the semiconductor / epitaxial layer.

In some examples, a biomimetic surface topography 605 may be utilized. In this example, the surface topography may mimic the structures of a moth's eye. Accordingly, nanostructures having similar geometry may be created on the top surface of the semiconductor / epitaxial layer. The nanostructures can provide a broadband and omnidirectional antireflective property that can surpass the performance of double layer coatings. In some examples, the biomimetic surface topography 605 may be have a paraboloid shape, and referred to as a paraboloid nipple array.

In some examples, a porous surface topography 610 may be utilized. In this example, nanometer-sized voids with a large hydrogenated surface may be utilized. The voids may form a plurality of peaks of variable height, and with variable distribution.

In further examples, a pyramidal surface topography 615 is provided, in which pyramidal structures are formed on the top surface of the semiconductor/epitaxial layer. In yet further embodiments, a grating topography 620 is provided. Specifically, pyramidal structures may be formed, in which the faces of the pyramid exhibit grating lines of variable width, height, and/or length. The faces themselves may have a relative angle that is fixed and/or variable along the height of the pyramid (e.g., from the base to the tip).

Fig. 7 illustrates a schematic perspective view of a photonic surface topography 700 featuring holes, in accordance with various embodiments. As depicted, in various embodiments, an array of holes may be created within the semiconductor layer. In some examples, the array of holes may be randomly distributed. In other examples, the array of holes may be arranged according to a pattern, grid, or other design.

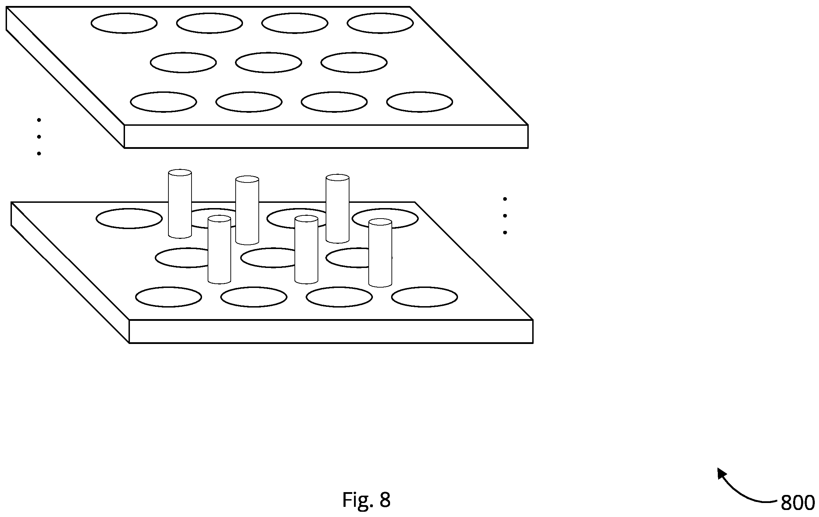

Fig. 8 illustrates a schematic perspective view of a photonic surface topography featuring multiple layers of holes and rods, in accordance with various embodiments. Like the surface topography 700, the surface topography 800 may feature a semiconductor layer with holes. The layer with holes may alternate with a layer of rods disposed on the semiconductor layer with holes. The layer of rods may separate a semiconductor layer with holes from a subsequent (e.g., adjacent) semiconductor layer having holes. Thus, a subsequent semiconductor layer with holes may be disposed on the layer of rods. In this way, the semiconductor layers with holes may alternate with layers of rods.

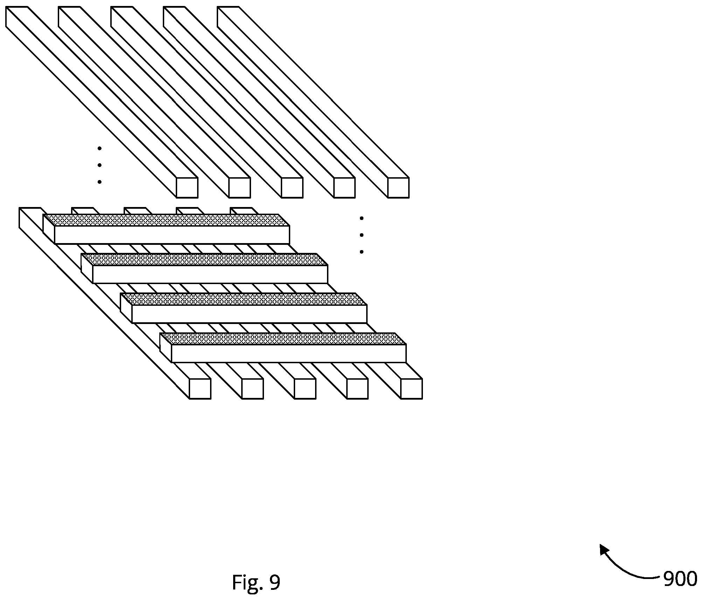

Fig. 9 illustrates a schematic perspective view of a photonic surface topography 900 featuring a lattice structure, in accordance with various embodiments. In various examples, a lattice structure may be formed on (or within) a semiconductor layer as described above. In some examples, the lattice structure may be formed using a plurality of elongated structures. The elongated structures may be formed of a dielectric material, for example, via an epitaxial process. The elongated structures may include, without limitation, structures such as fins, columns, trenches, or walls. The elongated structures may be formed on (or within) a semiconductor layer, such as semiconductor layer 110, 210, 310. In various examples, an array of elongated structures may be formed from the plurality of elongated structures. The array of elongated structures may co-extend in a longitudinal direction (e.g., parallel or near-parallel within the limits of manufacturing techniques and tolerances). A subsequent layer may be disposed on the array of elongated structures. The subsequent layer may similarly include an array of elongated structures that are parallel to each other, but offset at an angle from the elongated structures of the previous (e.g., underlying) layer. For example, in some embodiments, the elongated structures of any two adjacent layers may be arranged to be orthogonal to each other (e.g., the longitudinal axis of the elongated layers are orthogonal or near-orthogonal within the limits of manufacturing techniques and tolerances). In other examples, different angles of offset may be utilized, such as, without limitation, 30-degrees, 45-degrees, 60 degrees, etc.

By employing surface texturing and structures utilizing a photonic surface topography, photo-detection efficiency of individual SPADs and of the SiPM (e.g., SPAD array) may be improved over a broad range of wavelengths.

Moreover, the point-like p-n junction and corresponding point-like high field region of the SPADs allows for the surface texturing to be features over a larger area of the SPAD array, as compared to the typical planar p-n junction approach. The introduction of an AR topography to the top surface (e.g., a first side, or front side facing a light source) greatly improves photodetector efficiency and sensitivity by improving light transmission and randomization of light ray direction entering the semiconductor/epitaxial layer.

While some features and aspects have been described with respect to the embodiments, one skilled in the art will recognize that numerous modifications are possible. For example, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various embodiments. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various embodiments are described with or without some features for ease of description and to illustrate aspects of those embodiments, the various components and/or features described herein with respect to a particular embodiment can be substituted, added and/or subtracted from among other described embodiments, unless the context dictates otherwise. Consequently, although several embodiments are described above, it will be appreciated that the invention is intended to cover all modifications and equivalents within the scope of the following claims.

## Claims

1. A photodetector comprising:
a semiconductor layer (110) having a top surface on a first side, wherein the semiconductor layer (110) is configured to allow light to enter via the first side, the semiconductor layer (110) comprising:
a body having a first type of doping;
a first region (125) having a second type of doping different from the first type; and
wherein a first fraction of a surface area of the top surface of the semiconductor layer (110) comprises a surface topography;
wherein the semiconductor layer (110) further comprises a junction (120) formed between the body and the first region (125),
wherein the junction (120) is configured to have respective surface area that is a second fraction of the surface area of the top surface, wherein the second fraction is smaller than the first fraction; and
an electrode (135) coupled to the first region (125).

2. The photodetector of claim 1, further comprising:
a substrate (105) having the first type of doping of a different concentration than the body, wherein the semiconductor layer (110) is disposed on the substrate (105).

3. The photodetector of claim 2, wherein the semiconductor layer (110) is an epitaxial layer formed on the substrate (105).

4. The photodetector of claim 2 or 3, further comprising:
an insulation layer (555) disposed on the substrate (105), wherein the insulation layer (555) is formed of a dielectric material, and
wherein the semiconductor layer (110) is disposed on the insulation layer (555).

5. The photodetector of any of claims 2 to 4, further comprising a dielectric layer (115) disposed on the top surface of the semiconductor layer (110), and a trench (445) formed in the semiconductor layer (110), wherein the trench has a depth that extends from the top surface of the semiconductor to at least partially inside the substrate (105).

6. The photodetector of claim 5, wherein the trench (445) is filled with a dielectric material.

7. The photodetector of any of claims 1 to 6, wherein the first region (125) comprises a top portion disposed on the top surface of the semiconductor layer (110) and in contact with the electrode (135), a column that extends from the top portion into the body, and a tip portion at a first end of the column, wherein the junction (120) is formed between the tip portion and the body.

8. The photodetector of claim 7, further comprising an insulation channel formed around at least part of the column of the first region (125) and between the first region (125) and the body, wherein the insulation channel is configured to electrically insulate at least part of the first region (125) from the semiconductor layer (110).

9. The photodetector of any of claims 1 to 8, wherein the second type of doping is a heavy n-type doping, and wherein the junction (120) is a p-n junction.

10. The photodetector of any of claims 1 to 9, wherein the surface topography is a paraboloid nipple array.

11. An apparatus comprising:
a semiconductor layer (110) having a first surface, the semiconductor layer (110) comprising:
a body having a first type of doping;
a first region (125) having a second type of doping different from the first type; and
wherein a first fraction of a surface area of the first surface of the semiconductor layer (110) comprises a surface topography;
wherein the semiconductor layer (110) further comprises a junction (120) formed between the body and the first region (125), wherein the junction (120) is configured to have a surface area that is a second fraction of the surface area of the first surface, wherein the second fraction is smaller than the first fraction.

12. The apparatus of claim 11, further comprising:
a substrate (105) having the first type of doping, wherein the semiconductor layer (110) is disposed on the substrate (105).

13. The apparatus of claim 11 or 12, comprising at least one of the following features:
(i) further comprising:
an insulation layer (555) disposed on the substrate (105), wherein the insulation layer (555) is formed of a dielectric material, and wherein the semiconductor layer (110) is disposed on the insulation layer (555);
(ii) further comprising a dielectric layer (115) disposed on the first surface of the semiconductor layer (110), and a trench (445) formed in the semiconductor layer (110), wherein the trench (445) has a depth that extends from the first surface of the semiconductor to at least partially inside the substrate (105);
(iii) wherein the first region (125) comprises a top portion disposed on the first surface of the semiconductor layer (110) and in contact with the electrode (135), a column that extends from the top portion into the body, and a tip portion at a first end of the column, wherein the junction (120) is formed between the tip portion and the body.

14. A photodetector array comprising:
a plurality of photodetectors disposed on a substrate (105) in a grid arrangement, the plurality of photodetectors including a first photodetector, the first photodetector comprising:
a semiconductor layer (110) having a top surface on a first side, wherein the semiconductor layer (110) is configured to allow light to enter via the first side, the semiconductor layer (110) comprising:
a body having a first type of doping;
a first region (125) having a second type of doping different from the first type; and
wherein a first fraction of a surface area of the top surface of the semiconductor layer (110) comprises a surface topography;
wherein the semiconductor layer (110) further comprises a junction (120) formed between the body and the first region (125),
wherein the junction (120) is configured to have respective surface area that is a second fraction of the surface area of the top surface, wherein the second fraction is smaller than the first fraction.

15. The photodetector array of claim 14, comprising at least one of the following features:
(i) wherein the surface topography is a paraboloid nipple array;
(ii) wherein the first photodetector further comprises:
a substrate (105) having the first type of doping of a different concentration than the body, wherein the semiconductor layer (110) is disposed on the substrate (105); and
an insulation layer (555) disposed on the substrate (105), wherein the insulation layer (555) is formed of a dielectric material, and wherein the semiconductor layer (110) is disposed on the insulation layer (555);
(iii) further comprising a dielectric layer (115) disposed on the top surface of the semiconductor layer (110), and a trench (445) formed in the semiconductor layer (110), disposed at least partially between the first photodetector and an adjacent photodetector of the plurality of photodetectors, wherein the trench (445) has a depth that extends from the top surface of the semiconductor to at least partially inside the substrate (105);
(iv) wherein the first region (125) comprises a top portion disposed on the top surface of the semiconductor layer (110) and in contact with the electrode (135), a column that extends from the top portion into the body, and a tip portion at a first end of the column, wherein the junction (120) is formed between the tip portion and the body.
